# EUROPEAN PATENT SPECIFICATION

(11) **EP 2 953 116 B1**
(45) Date of publication and mention of the grant of the patent: **27.11.2019**
(21) Application number: 13874106.1
(22) Date of filing: 31.12.2013
(51) Int. Cl.: G09F 9/30, G02F 1/1333

(54) **DISPLAY APPARATUSES**
ANZEIGEVORRICHTUNGEN
DISPOSITIFS D'AFFICHAGE

(30) Priority: 04.02.2013 CN 201310044954
(43) Date of publication of application: 09.12.2015
(73) Proprietor: Xiaomi Inc., Beijing 100085 (CN)
(72) Inventor: XU, Duo, Beijing 100085 (CN); LIN, Bin, Beijing 100085 (CN); LEI, Jun, Beijing 100085 (CN)
(74) Representative: Delumeau, François Guy
(86) International application number: PCT/CN2013/091018
(87) International publication number: WO 2014/117621

(56) References cited:
- CN-A- 101 340 471
- CN-A- 101 387 790
- CN-A- 103 137 024
- CN-U- 203 351 134
- JP-A- 2013 020 176
- KR-A- 20120 055 086
- US-A1- 2012 236 540

## Description

### TECHNICAL FIELD

The invention generally relates to the field of display and, more particularly, to a display apparatus.

### BACKGROUND

With the development of mobile terminals, the display apparatus has become particularly important. The display apparatus used in the conventional mobile terminal such as a mobile phone or a tablet computer is usually a display screen based on the RGB (Red, Green, Blue) color mode.

The light emitting and display layer of the display screen takes a pixel as a display unit, and a control circuit is provided around each display unit. In the RGB color mode, one intensity value with a range of 0-255 is distributed to RGB components of each pixel in an image by using the RGB model, and each RGB color is controlled by the circuit provided around each display unit (i.e. pixel), so as to display color images.

The mainstream display screen often used conventionally includes a TFT (Thin Film Transistor) screen, an OLED (Organic Light-Emitting Diode) screen, a STN (Super Twisted Nematic) screen, a PDP (Plasma Display Panel) screen, etc. The display effect is increasingly trusted by the users as the improvements of the light transmittance and color rendition.

However, due to requirements for increasing and thinning the screen of the mobile terminal by the users, the display screen has been the main power-hungry apparatus in the mobile terminal, thus the standby time is influenced and the user experience is deteriorated.

Document US 2012/236540 A1 discloses devices and methods for providing integrated photovoltaic cells.

### SUMMARY

The embodiments of the invention disclosed in claims 1, 6 and 14, provide a display apparatus and a device, which can absorb light energy and convert it to electrical energy for use by a mobile terminal without affecting the display effect, and the standby time of the mobile terminal can be increased and the user experience can be improved.

According to a first aspect of the invention, the invention provides a display apparatus, comprising a light emitting and display layer, and a supporting layer, wherein the light emitting and display layer is located above the supporting layer and is used for displaying an image by emitting light;
the supporting layer comprises an array formed by a photovoltaic material, the array is located horizontally and directly under driving circuits in the light emitting and display layer, and the array formed by the photovoltaic material forms a circuit path for absorbing the light emitted from the light emitting and display layer and convert it into current.

In a particular embodiment, the supporting layer is made by embedding the photovoltaic material in a reflector.

In a particular embodiment, the array formed by the photovoltaic material is located horizontally and directly under a preset part of the driving circuits or all of the driving circuits in the light emitting and display layer.

In a particular embodiment, the photovoltaic material may be any one or a combination of the following materials:
An amorphous silicon, a microcrystalline silicon, a cadmium telluride thin film solar cell and a thin film solar cell.

In a particular embodiment, the light emitting and display layer includes a cathode, a reflector, a conductive layer and an anode that are arranged in an order from top to bottom,
when the cathode and the anode are applied with voltage, electrons in the conductive layer are transmitted to the reflector and holes are formed in the conductive layer, then the holes transit to the reflector, recombine with the electrons and release energy to emit light.

In a particular embodiment, the display apparatus further includes: a touching layer, the touching layer is located above the light emitting and display layer and is used for responding to a tap signal.

In a particular embodiment, gaps in the array formed by the photovoltaic material totally reflect a preset part of visible light.

In a particular embodiment, the array formed by the photovoltaic material is obtained by multiple linear photovoltaic material parts being arranged in the horizontal direction of the display apparatus.

Thus, the above embodiment provides a display apparatus, which comprises a light emitting and display layer, and a supporting layer; wherein the light emitting and display layer is located above the supporting layer and is used for displaying an image by emitting light; the supporting layer includes an array formed by a photovoltaic material, the array is located horizontally and directly under driving circuits in the light emitting and display layer, and the array formed by the photovoltaic material forms a circuit path for absorbing the light emitted from the light emitting and display layer and convert it into current. In the display apparatus provided by the embodiments of the invention, the photovoltaic material is embedded in the corresponding position in the supporting layer under the driving circuits of the display layer, and the photovoltaic material forms a circuit path, thus the light emitted from the display layer can be absorbed and converted into current without affecting the light emitting of the display layer, and through applying the current converted from the light energy to a mobile terminal, a standby time of the mobile terminal can be increased and the user experience is improved.

The device provided by the present embodiment can operate by using the electrical energy obtained by converting light by the above described display apparatus, and the standby time of the device can be increased and the user experience can be improved without influencing the display effect experienced by the user.

According to the invention, the invention provides a display apparatus, comprising a supporting layer, a backlight layer and a display layer;
wherein the display layer is located above the backlight layer and has an array formed by a photovoltaic material, the array uniformly forms multiple light transmitting units on the horizontal plane of the display layer, and the array formed by the photovoltaic material forms a path for absorbing light emitted from the backlight layer or ambient light and converts it into current;
the backlight layer is used for providing light source for the display layer, and the supporting layer is located under the backlight layer and is used for providing a support for the display layer and the backlight layer, wherein the supporting layer is a reflector which is used for reflecting light emitted downward from the backlight layer.

In a particular embodiment, the light transmitting units are linear apertures or circular apertures.

In a particular embodiment, the light emitting and display layer further includes micro lenses each of which is correspondingly located under each linear aperture, the micro lens is used for focusing light blocked by the photovoltaic material and refracting it to an upward side of the photovoltaic material.

In a particular embodiment, a shape of the micro lens in a top view is a linear shape along the linear aperture.

In a particular embodiment, the micro lens is any one of the following lenses:
a single convex lens, a single concave lens, a biconvex lens, a biconcave lens, or a symmetric or asymmetric spherical lens.

In a particular embodiment, the refractive index of the micro lens is a preset refractive index.

In a particular embodiment, the display layer comprises an upper polarizer, a color glass filter, a thin film field effect glass sheet and a down polarizer in an order from top to bottom;
the photovoltaic material is embedded in the upper polarizer, the embedding position of the photovoltaic material is directly above a preset part of driving circuits or all of the driving circuits in the display layer, and light transmitting units are formed in regions of the upper polarizer except the embedding position.

In a particular embodiment, the photovoltaic material is any one or a combination of the following materials:
an amorphous silicon, a microcrystalline silicon, a cadmium telluride thin film solar cell and a thin film solar cell.

In a particular embodiment, the supporting layer is a reflector which is used for reflecting light emitted downward from the backlight layer.

In a particular embodiment, the display apparatus further comprises a touching layer,
the touching layer is located above the display layer and is used for responding to the tap signal.

In a particular embodiment, the light transmitting units are transparent to a preset part of visible light.

In a particular embodiment, the light transmitting units are obtained by multiple linear photovoltaic material parts being arranged in the horizontal direction of the display apparatus.

The embodiments of the invention provides a display apparatus, which includes a display layer, a backlight layer and a supporting layer; wherein the display layer is located above the backlight layer and has an array formed by a photovoltaic material, the array uniformly forms multiple light transmitting units on the horizontal plane of the display layer, and the array formed by the photovoltaic material forms a path for absorbing light emitted from the backlight layer or ambient light and converts it into current; the backlight layer is used for providing light source for the display layer, and the supporting layer is located under the backlight layer and is used for providing a support for the display layer and the backlight layer. In the display apparatus provided by the embodiments of the invention, the photovoltaic material is uniformly embedded in the display layer, the array formed by the photovoltaic material forms light transmitting units, and the photovoltaic material forms a path, thus the light emitted from the backlight layer or the ambient light can be absorbed and converted into current without affecting the light emitting of the display layer, and through applying the current converted from the light energy to a mobile terminal, a standby time of the mobile terminal can be increased and the user experience is improved.

According to a fourth aspect of the invention, the invention provides a device, the device includes the above described display apparatus, and the device receives and uses the current outputted from the display apparatus.

The device provided by the present embodiment can operate by using the electrical energy obtained by converting light by the above described display apparatus, and the standby time of the device can be increased and the user experience can be improved without influencing the display effect experienced by the user.

It is to be understood that the foregoing general description and the following detailed description are exemplary and explanatory only and are not restrictive of the invention.

### BRIEF DESCRIPTION OF THE DRAWINGS

Fig. 1 is a cross-section diagram of a structure of a display apparatus according to the first embodiment of the invention;
Fig. 2 is a schematic diagram of position where a photovoltaic material is embedded in a reflector according to the first embodiment of the invention;
Fig. 3 is an exemplary plan view of one arrangement manner of a photovoltaic material in the supporting layer according to the first embodiment of the invention;
Fig. 4 is an exemplary plan view of the second arrangement manner of a photovoltaic material in the supporting layer according to the first embodiment of the invention;
Fig. 5 is a schematic diagram of a pixel configuration of each display layer according to the first embodiment of the invention;
Fig. 6 is a cross-section diagram of a structure of one type of light emitting and display layer according to the first embodiment of the invention;
Fig. 7 is a schematic diagram of a structure of the second type of light emitting and display layer according to the first embodiment of the invention;
Fig. 8 is a cross-section diagram of a structure of another display apparatus according to the first embodiment of the invention;
Fig. 9 is a schematic diagram of a mobile phone with a display apparatus according to the second embodiment of the invention;
Fig. 10 is a cross-section diagram of a structure of a display apparatus according to the third embodiment of the invention;
Fig. 11 is a plan view of transmittance units and an arrangement of the transmittance units in the display layer according to the third embodiment of the invention;
Fig. 12 is a plan view of another transmittance units and an arrangement of the transmittance units in the display layer according to the third embodiment of the invention;
Fig. 13 is a schematic diagram of an arrangement position of a photovoltaic material in the display layer according to the third embodiment of the invention;
Fig. 14 is a schematic diagram of another arrangement position of a photovoltaic material in the display layer according to the third embodiment of the invention;
Fig. 15 is a schematic diagram of further another arrangement position of a photovoltaic material in the display layer according to the third embodiment of the invention;
Fig. 16 is a plan view of a connecting way of the photovoltaic material in the display layer according to the third embodiment of the invention;
Fig. 17 is a plan view of another connecting way of the photovoltaic material in the display layer according to the third embodiment of the invention;
Fig. 18 is a cross-section diagram of a structure of a display layer according to the third embodiment of the invention;
Fig. 19 is a cross-section diagram of a structure of a display apparatus added with micro lenses according to the third embodiment of the invention;
Fig. 20 is a schematic diagram of a micro lens according to the third embodiment of the invention;
Fig. 21 is a cross-section diagram of a structure of another display apparatus added with a micro lens according to the third embodiment of the invention;
Fig. 22 is a schematic diagram of another micro lens according to the third embodiment of the invention
Fig. 23 is a cross-section diagram of a structure of another display apparatus according to the third embodiment of the invention;
Fig. 24 is a schematic diagram of a mobile phone with a display apparatus according to the fourth embodiment of the invention.

Specific embodiments in this disclosure have been shown by way of example in the foregoing drawings and are hereinafter described in detail. The figures and written description are not intended to limit the scope of the inventive concepts in any manner. Rather, they are provided to illustrate the inventive concepts to a person skilled in the art by reference to particular embodiments.

### DETAILED DESCRIPTION

Hereinafter, implementations of a display apparatus and a device according to the embodiments of the invention will be described in detail in conjunction with the drawings.

### First embodiment

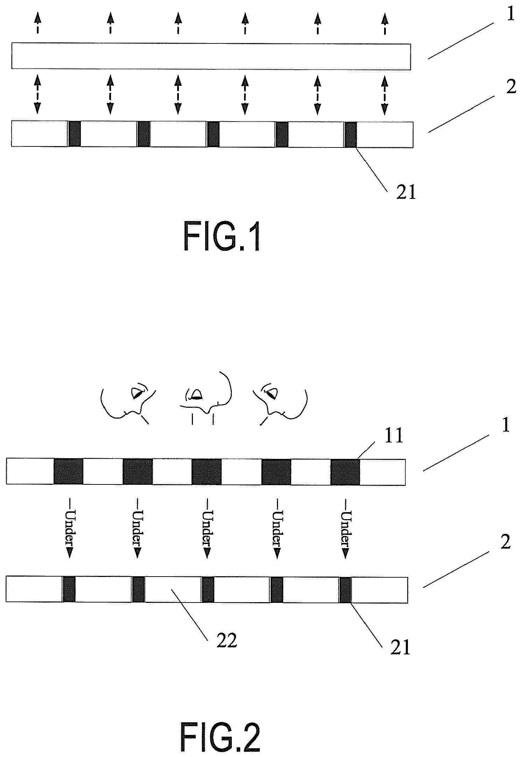

As illustrated in Fig 1, the present embodiment provides a display apparatus, including:
a light emitting and display layer 1, and a supporting layer 2;
wherein the light emitting and display layer 1 is located above the supporting layer 2 and is used for displaying an image by emitting light;
the supporting layer 2 includes an array formed by a photovoltaic material 21, the array is positioned horizontally and directly under driving circuits in the light emitting and display layer 1, and parts of the photovoltaic material 21 in the array are connected and form a path (or the array formed by the photovoltaic material forms a path) for absorbing the light emitted from the light emitting and display layer 1 and converting the light into current.

Preferably, in the present embodiment, the above described display apparatus is a display screen.

In the prior art, to enable the display screen to display different colors, the display screen displays colors based on a RGB model. And the display screen takes an individual pixel as a display unit. To achieve different collocation of RGB colors, a driving circuit needs to be disposed around each pixel, for example, a TFT array may be disposed in a display layer of a TFT screen.

In the display screen provided by the embodiments of the invention, the photovoltaic material is provided in the supporting layer 2 of the screen. For not affecting the light emitting of the screen, the photovoltaic material 21 is embedded in a reflector, which is one preferable embodiment.

One preferable embedding manner may be as follows: a groove is formed at a preset position of the reflector by photolithography, and then the photovoltaic material 21 is provided in the groove. The depth of the groove is optional and related to a photon-to-electron conversion efficiency of the photovoltaic material 21.

Moreover, as illustrated in Fig. 2, the embedding position of the photovoltaic material 21 in the reflector should be a preset position, assuring that after the light emitting and display layer 1 of the display screen is installed above the supporting layer 2, the embedding position is under a part or all of a driving circuit region 11. A region in the supporting layer 2 except the photovoltaic material 21 is occupied by a reflective material 22. The reflective material 22 is used for replacing the original reflector and reflecting back the light emitted from the light emitting and display layer 1 so as to increase a brightness of the display screen.

As a preferable embodiment, the array of the photovoltaic material 21 is located horizontally and directly under the driving circuits of a preset part or all of the driving circuits in the light emitting and display layer 1, to avoid that the reflected light is too little and the brightness of the screen is reduced.

The arrangement scheme of the photovoltaic material 21 illustrated in Fig. 2 is that the horizontal area of the photovoltaic material 21 is less than that of the driving circuits 11.

In order to fully explain this scheme, the following two arrangement manners of the photovoltaic material are provided by the present embodiment.

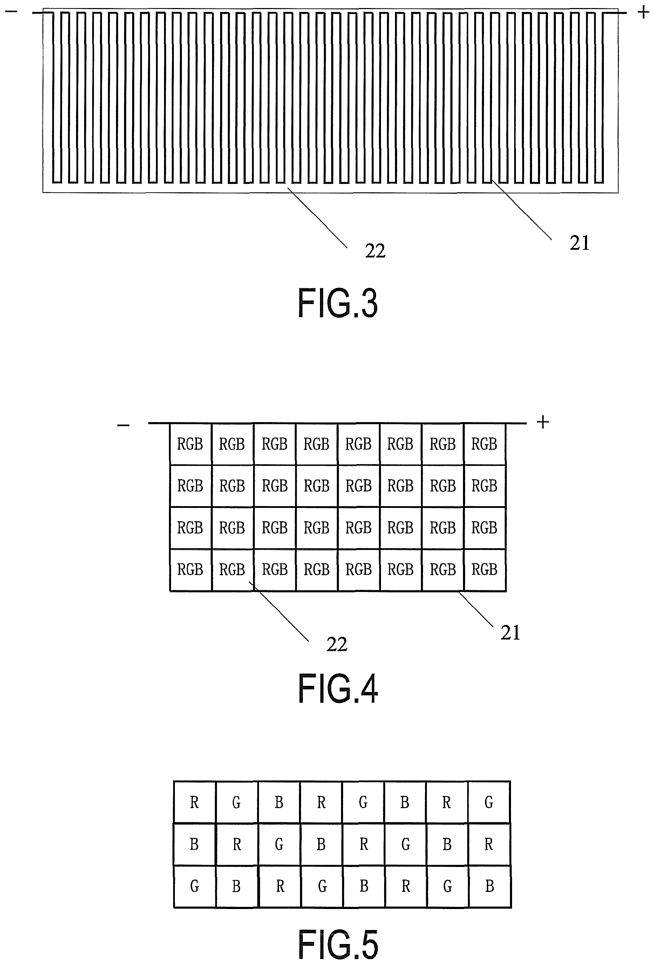

Fig. 3 shows a plan view of the supporting layer 2, which is the first arrangement manner of the photovoltaic material provided by the present embodiment.

The array formed by the photovoltaic material 21 is made by arranging multiple linear photovoltaic materials in the horizontal direction of the display apparatus (horizontal direction of the display apparatus, such as the face direction of the display apparatus), and gaps in the array of the photovoltaic material are occupied by the reflective material 22 which functions as the reflector in the prior art. The array consisted of the photovoltaic material forms a loop which includes two poles of "+" and "-', so that the current obtained by the conversion can be transmitted to an electric energy storage device or an electric energy consumption device.

Fig. 4 shows a plan view of the supporting layer 2, which is the second arrangement manner of the photovoltaic material provided by the present embodiment.

The display takes a pixel as a display unit, and each display unit includes three colors, i.e., RGB. In Fig. 4, each RGB indicates a region in the supporting layer corresponding to a region directly under each pixel in the display layer. The photovoltaic material 21 is provided around each of the corresponding pixel regions to form an array, and each of the corresponding pixel regions is provided with the reflective material 22 which functions as the reflector in the prior art. The array consisted of the photovoltaic material forms a loop which includes two poles of "+" and "-", so that the current obtained by the conversion can be transmitted to an electric energy storage device or an electric energy consumption device.

To provide more implementations, the photovoltaic material may be provided in gap regions in each pixel. Fig. 5 illustrates the composition of each pixel in the display layer, wherein each of R, G, B indicates one color of each pixel. The driving circuits such as a TFT array are also positioned in a connecting part (i.e., black line part) of each color to control each color, and the photovoltaic material may also be provided in a region of the supporting layer corresponding to the connecting part of each color.

It should be noted that, the arrangement form of the photovoltaic material in the supporting layer is not limited by the embodiments of the invention. The preferable arrangement manner is arranging the photovoltaic material uniformly without affecting the reflective effect of the supporting layer.

Preferably, the photovoltaic material used in the first embodiment may be any one or a combination of the following materials, but is not limited to these materials, any material with photon-to-electron conversion function is available:
an amorphous silicon, a microcrystalline silicon, a cadmium telluride thin film solar cell and a thin film solar cell.

It should be noted that, the display apparatus provided by the invention is applicable for any display screen. To testify the implementations, the embodiments of the invention provide the following explanations.

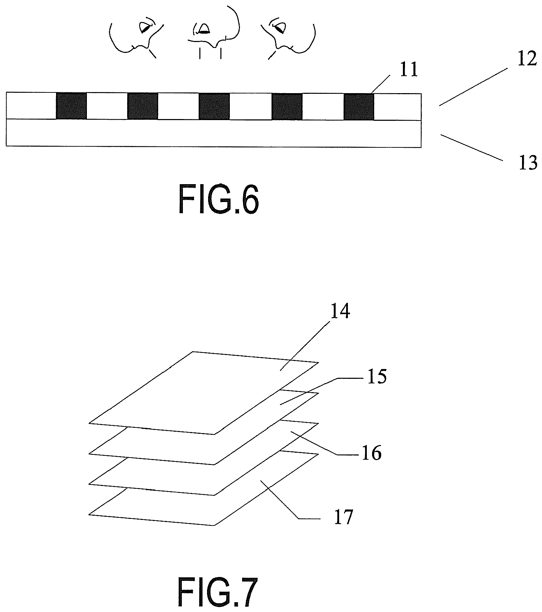

Taking the implementation on the non-self-luminous screen (for example, a TFT screen) as an example, as illustrated in Fig. 6, the light emitting and display layer 1 includes a display layer 12 and a backlight layer 13.

The backlight layer 13 is located under the display layer 12 and is used for providing backlight for the display layer 12.

The display layer 12 is used for controlling a display color of each pixel according to the driving circuit 11 and displaying an image under the backlight provided by the backlight layer 13.

In the display screen shown in Fig. 6, since the screen cannot illuminate itself and needs a backlight layer to provide a light source, such that an image could be displayed after the light source is illuminated on the display layer, the driving circuits 11 are provided in the display layer 12 to control the color of the image.

Taking the implementation on the self-luminous screen (for example, an OLED screen) as an example, as illustrated in Fig. 7, the light emitting and display layer 1 includes a cathode 14, a reflector 15, a conductive layer 16 and an anode 17 arranged in an order from top to bottom.

When the cathode 14 and the anode 17 are applied with a voltage, electrons in the conductive layer 16 are transmitted to the reflector 15 and holes are formed in the conductive layer 16, then the holes transit to the reflector 15, recombine with the electrons and release energy to emit light.

As a preferable embodiment, a thin film transistor (TFT) array may cover the anode 17, and the luminescence of the pixel is determined by the TFT array (i.e., driving circuit) to display the color image.

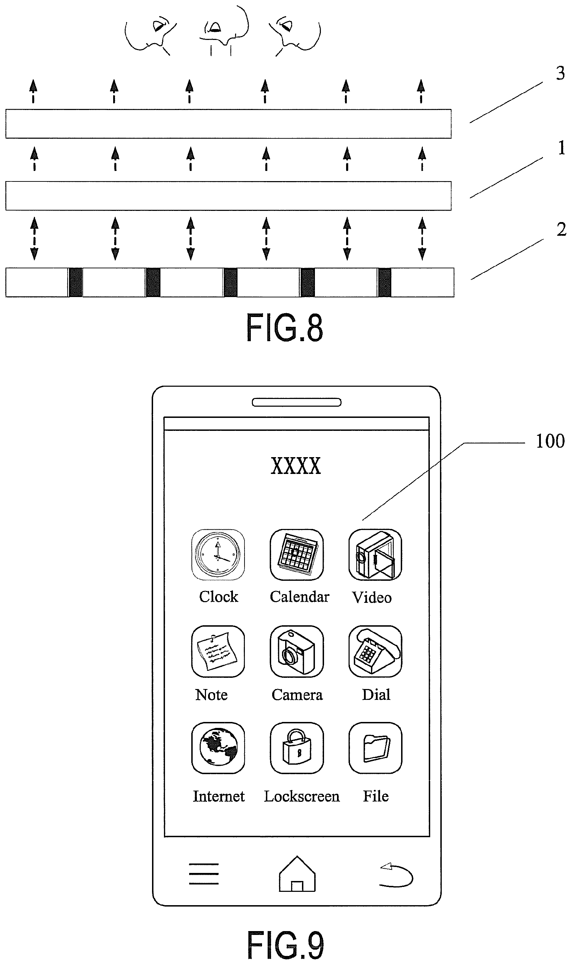

Preferably, as illustrated in Fig. 8, the display apparatus provided by the present embodiment also includes a touching layer 3.

The touching layer is located above the light emitting and display layer 1 and is used for responding to a tap signal.

After additionally installing the touching layer 3 above the light emitting and display layer 1, the display apparatus may achieve the function of touching screen. The touching layer 3 responds to the tap signal from the user and transmits the signal to the processor for processing. The touching layer 3 includes, but is not limited to, a resistive touch screen, a capacitive touch screen, etc.

The embodiments of the invention provide a display apparatus, which includes a light emitting and display layer, and a supporting layer; wherein the light emitting and display layer is located above the supporting layer and is used for displaying an image by emitting light; the supporting layer includes an array formed by a photovoltaic material, the array is positioned horizontally and directly under a driving circuit in the light emitting and display layer, and the array formed by the photovoltaic material forms a circuit path for absorbing light emitted from the light emitting and display layer and converting the light into current. In the display apparatus provided by the embodiments of the invention, the photovoltaic material is embedded in the corresponding position in the supporting layer under the driving circuits of the display layer, and the photovoltaic material forms a circuit path, thus the light emitted from the display layer can be absorbed and converted into current without affecting the light emitting of the display layer, and through applying the current converted from the light energy to a mobile terminal, the standby time of the mobile terminal can be increased and the user experience is improved.

### Second embodiment

The present embodiment provides a device, which includes the display apparatus according to the first embodiment, and the device receives and uses the current provided by the display apparatus.

In the present embodiment, preferably, the device is a mobile terminal. After the display apparatus provided by the first embodiment is installed as a display screen in the mobile terminal, while using a portable power source, the mobile terminal also can receive the current obtained by the photoelectric conversion in the display apparatus for its operation or receive the current and store it in the portable power source for standby application. Thus, the light source emitted from the display screen itself can be reused and recycled, the maximum efficiency of electrical energy can be achieved, the standby time of the mobile terminal can be increased, and the user experience can be improved.

In the present embodiment, the device is not limited to the mobile terminal such as a mobile phone, a tablet, and a laptop, and it is applicable for any device with a display screen, such as a TV, a desktop computer.

Fig. 9 illustrates a schematic diagram of a mobile phone installed with any one of the display apparatuses according to the first embodiment. The display apparatus 100 is any one of the display apparatuses in the first embodiment. After the mobile phone is installed with the display screen 100, the photovoltaic material in the display apparatus can form a current loop which is connected with a power source of the mobile phone or an electrical apparatus. When the display apparatus 100 of the mobile phone emits light, the photovoltaic material absorbs the light and converts it to electrical energy for use by the mobile phone.

The device provided by the present embodiment can operate by using the electrical energy obtained by converting light by the above described display apparatus, and the standby time of the device can be increased and the user experience can be improved without influencing the display effect experienced by the user.

### Third embodiment

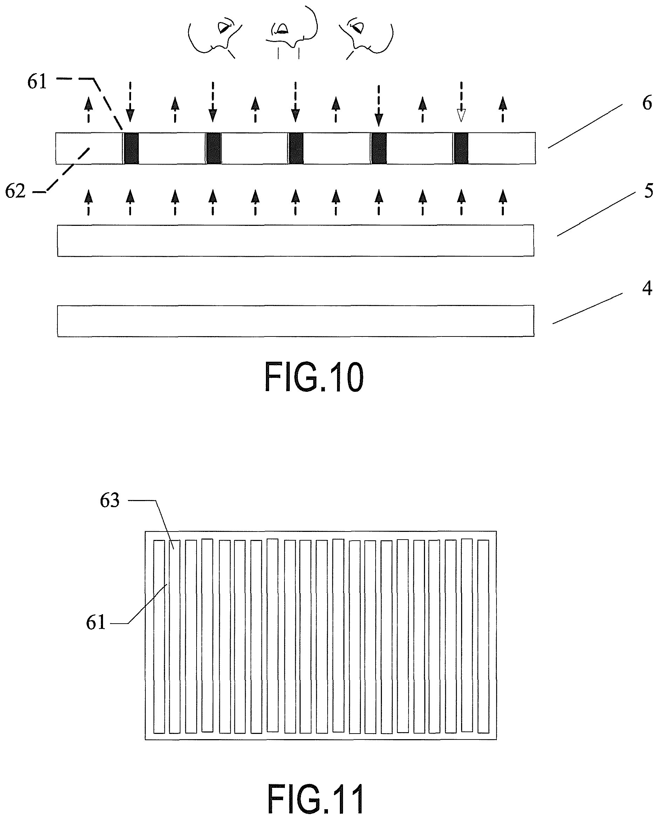

As illustrated in Fig. 10, the embodiments of the invention provide a display apparatus, which includes a supporting layer 4, a backlight layer 5 and a display layer 6.

The display layer 6 is located above the backlight layer 5 and has an array formed by a photovoltaic material 61, the array uniformly forms multiple light transmitting units 62 on the horizontal plane of the display layer 6, and the photovoltaic material 61 of the array forms a path for absorbing light emitted from the backlight layer 5 or the ambient light and convert it into current.

The backlight layer 5 provides a light source for the display layer 6, and the supporting layer 4 is located under the backlight layer 5 and provides a support for the display layer 6 and the backlight layer 5.

Preferably, in present embodiment, the above described display apparatus is a display screen.

In prior art, to enable the display screen to display different colors, the display screen displays colors based on a RGB model. And the display screen takes each pixel as a display unit. To achieve different collocation of RGB colors, a driving circuit needs to be disposed around each pixel, for example, a TFT array may be disposed in a display layer of a TFT screen.

Preferably, in present embodiment, the supporting layer 4 may be a reflector (i.e., a reflective material), which can reflect back the light emitted downward from the backlight layer 5 to increase the brightness of the display screen.

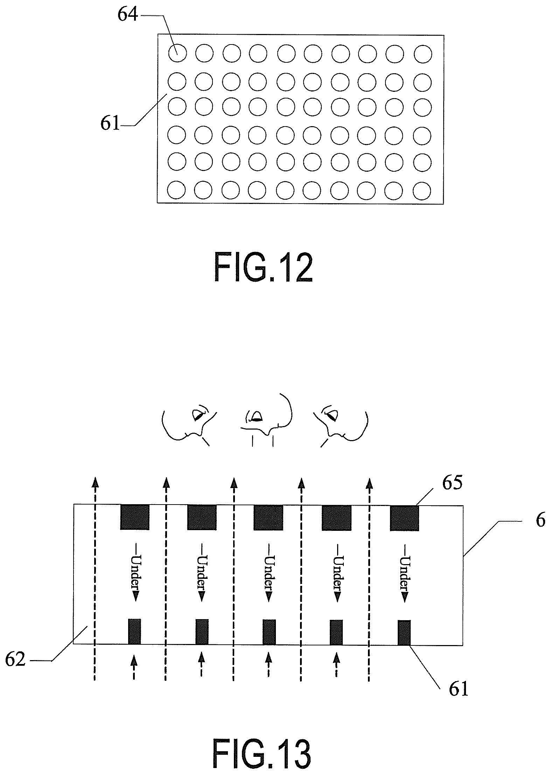

It should be noted that, in the present embodiment, as illustrated in Fig. 11 or Fig. 12, the light transmitting units 62 are preferably linear apertures 63 or circular apertures 64. However, the light transmitting units 62 are not limited to the linear aperture or the circular aperture, and may also be other shapes such as a rectangle, a polygon, or a combination of various shapes.

Preferably, the photovoltaic material used in the third embodiment may be any one or a combination of the following materials, but is not limited to these materials, any material with photon-to-electron conversion function is available:
an amorphous silicon, a microcrystalline silicon, a cadmium telluride thin film solar cell and a thin film solar cell.

In order to not affect the light emission of the display apparatus by the photovoltaic material 61, the third embodiment preferably provides two implementation manners.

In the first implementation manner, the photovoltaic material 61 is embedded in a preset position in the display layer, the preset position being directly above or directly under a part or all of the driving circuits in the display apparatus, or the photovoltaic material is provided at both a position directly above a part or all of the driving circuits in the display apparatus and a position directly under a part or all of the driving circuits in the display apparatus.

It should be noted that, in order to enable the display screen to control displaying images, a driving circuit 65 (for example, a TFT array) is included in the display layer 6, and is used for controlling the display color of the pixel.

As illustrated in Fig. 13, the photovoltaic material 61 is located under the driving circuits 65 in the display layer 6. In order to not block the light emitted from the display screen by the photovoltaic material 61, the horizontal area of the photovoltaic material 61 is less than the horizontal area of the driving circuit 65, at the same time, the object that the photovoltaic material 61 absorbs the light emitted from the backlight layer 5 to convert it into the electrical energy can be achieved. The parts denoted by the dashed line in Fig. 13 represent the state of the divergence of light. As shown in Fig. 13, the light can be normally dispersed out through the light transmitting units 62 without affecting the brightness of the screen.

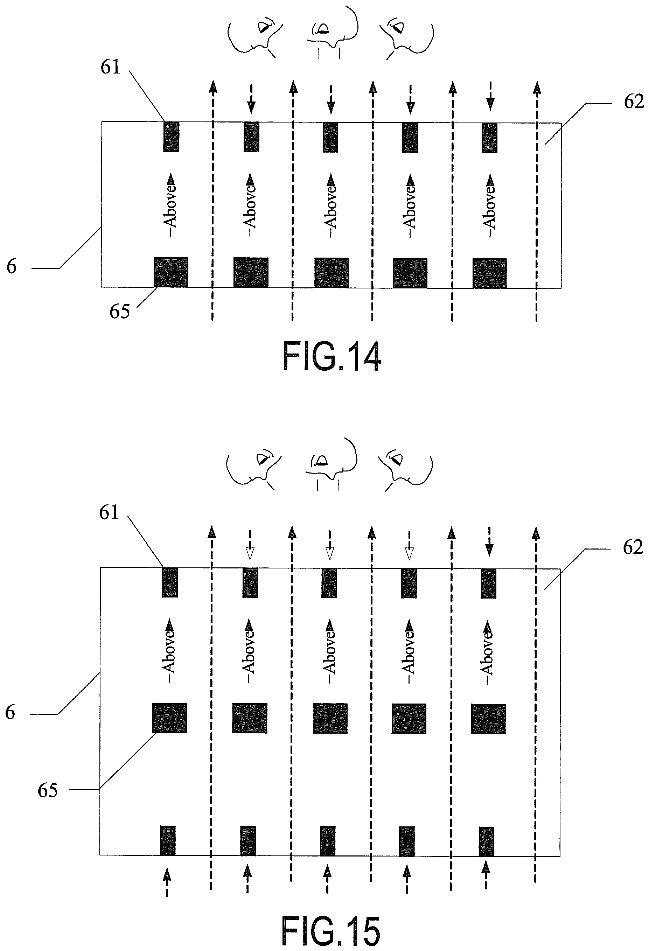

As illustrated in Fig. 14, the photovoltaic material 61 is directly above the driving circuits 65 in the display layer 6. In order to not block the light emitted from the display screen by the photovoltaic material 61, the horizontal area of the photovoltaic material 61 is less than the horizontal area of the driving circuit 65, at the same time, the object that the photovoltaic material 61 absorbs the light emitted from the backlight layer 5 and converts it into the electrical energy can be achieved. The parts denoted by the dashed line in the present embodiment represent the state of the divergence of light. The light can be normally dispersed out through the light transmitting units 62 without affecting the brightness of the screen.

As illustrated in Fig. 15, the photovoltaic material 61 is provided directly above and directly under the driving circuit 65 in the display layer 6. In order to not block the light emitted from the display screen by the photovoltaic material 61, the horizontal area of the photovoltaic material 61 is less than the horizontal area of the driving circuit 65. The parts denoted by the dashed line in Fig. 15 represent the state of the divergence of light. As shown in Fig. 15, the light can be normally dispersed out through the light transmitting units 62 without affecting the brightness of the screen. The photovoltaic material 61 directly under the driving circuit 65 may absorb the light emitted from the backlight layer 5, and the photovoltaic material 61 directly above the driving circuit 65 may absorb the ambient light, then the absorbed light is converted into electronic energy.

Preferably, the manner of embedding the photovoltaic material 61 in the display layer 6 may be as follows: a groove is formed at a preset position of the reflector by photolithography, and then the photovoltaic material 61 is provided in the groove. The depth of the groove is optional and related to the photon-to-electron conversion efficiency of the photovoltaic material 61.

In the third embodiment, when disposing the photovoltaic material in the display layer 6, a connection between the photovoltaic materials 61 shall be assured so that a current loop can be formed in the photovoltaic materials 61.

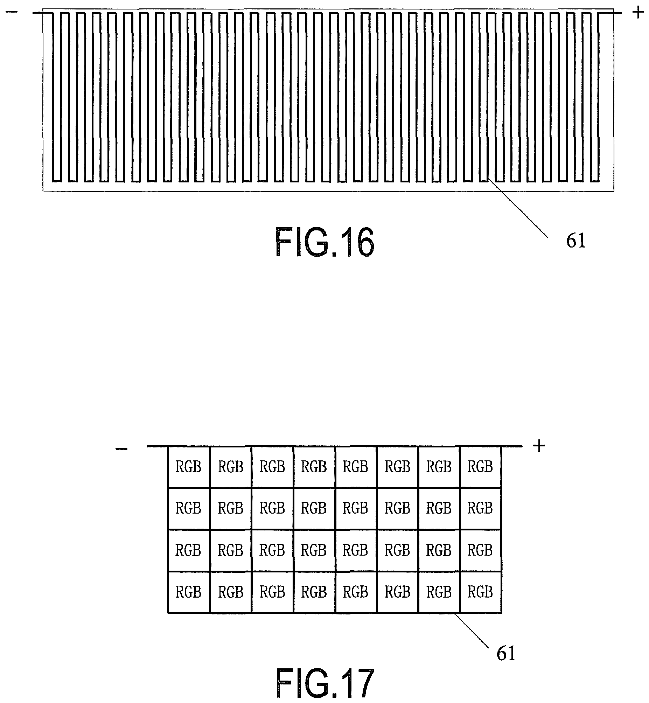

Fig. 16 shows a plan view of a display layer 6, in which one connection manner of the photovoltaic materials is provided.

The photovoltaic materials are arranged in the display layer 6 in a form of linear array, and are connected head to tail to form a path which includes two poles of "+" and "-" so that the current obtained by the conversion can be transmitted to an electric energy storage device or an electric energy consumption device.

Fig. 17 shows a plan view of a display layer 6, in which another connection manner of the photovoltaic materials is provided.

The photovoltaic materials are arranged in the display layer 6 in a form of multiple rectangle boxes to form an array, and are connected head to tail to form a path which includes two poles of "+" and "-" so that the current obtained by the conversion can be transmitted to an electric energy storage device or an electric energy consumption device. In order to not block the light emitted from the display screen by the photovoltaic material, the embedding positions of the photovoltaic materials 61 are corresponding to the driving circuits, that is, the photovoltaic materials 61 are provided around each RGB pixel.

To testify the actionability of the schemes of the present embodiment, a display layer structure used in an OLED display screen is provided by the present embodiment.

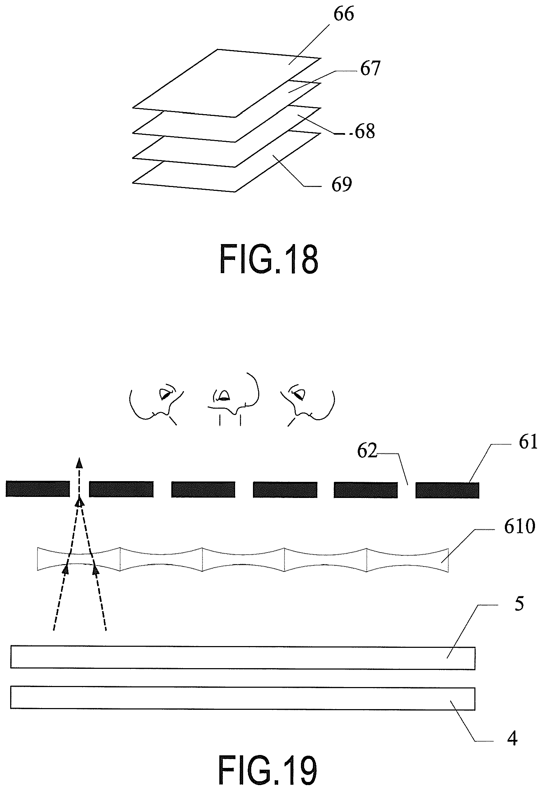

Fig. 18 shows a structure of the OLED display layer, wherein, the display layer 6 includes an upper polarizer 66, a color glass filter 67, a thin film field effect glass sheet 68 and a lower polarizer 69 in an order from top to bottom.

The photovoltaic materials are embedded in the upper polarizer 66, and the embedding position of the photovoltaic materials is directly above a preset part of the driving circuits or directly above all the driving circuits in the display layer 6. The light transmitting units are formed in regions in the upper polarizer except the embedding position.

In the second implementation manner, micro lenses are provided under the light transmitting units 62, the micro lens being used for focusing the light blocked by the photovoltaic materials and then refracting it to an upward side of the photovoltaic material.

After embedding the photovoltaic material in the display layer 6, the light emitted from the screen may be weakened due to the light-absorbing of the photovoltaic material, and the visual effect experienced by the user may be influenced. Preferably, the light under the photovoltaic materials and emitted from the backlight layer 5 is focused by the micro lenses and then is refracted onto the photovoltaic material.

For illustration purposes, the present embodiment provides an approach for the light transmitting units having linear apertures in Fig. 11. Fig. 19 is a cross-section diagram of a display layer added with micro lenses.

As shown in Fig. 19, the display apparatus includes a supporting layer 4, a backlight layer 5 and a display layer, the display layer consists of the photovoltaic materials 61, the light transmitting units 62 and the micro lenses 610, and the micro lens 610 may be a biconcave lens. The horizontal area of the photovoltaic material increases, and the light transmitting units 62 are insufficient to provide a high transmittance for the user. Thus, micro lenses 610 are added under the light transmitting units 62. The micro lenses 610 focus the light under the photovoltaic materials 61 and emit it upwards to the user by a refraction effect, thus the transmittance of the display screen can be enhanced.

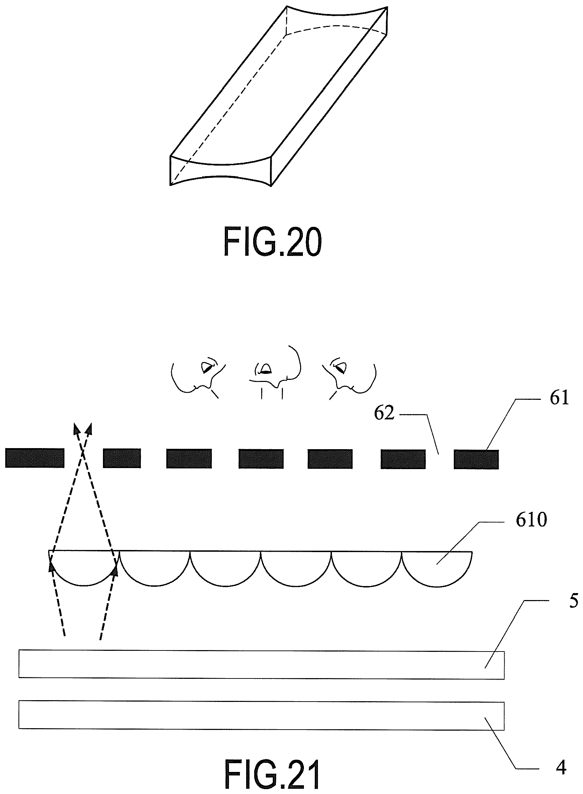

In view of the light transmitting units with linear apertures shown in Fig. 11, Fig. 20 provides linear biconcave lenses, which are positioned under the light transmitting units. Preferably, in the present embodiment, the micro lens can be any one of the following lenses, which can be combined and positioned under the light transmitting units:
a single convex lens, a single concave lens, a biconvex lens, a biconcave lens, a symmetric spherical lens or an asymmetric spherical lens.

As illustrated in Fig. 21, the present embodiment further provides a display apparatus added with another type of micro lenses, wherein, the display apparatus includes a supporting layer 4, a backlight layer 5 and a display layer, the display layer consists of the photovoltaic materials 61, the light transmitting units 62 and the micro lenses 610, the micro lens 610 may be a single concave lens. The horizontal area of the photovoltaic material is increased, and the light transmitting units 62 are insufficient to provide a high transmittance for the user. Thus, the micro lenses 610 are added under the light transmitting units 62. The micro lenses 610 focus the light under the photovoltaic materials 61 and emit it upwards to the user by a refraction effect, thus the transmittance of the display screen can be enhanced.

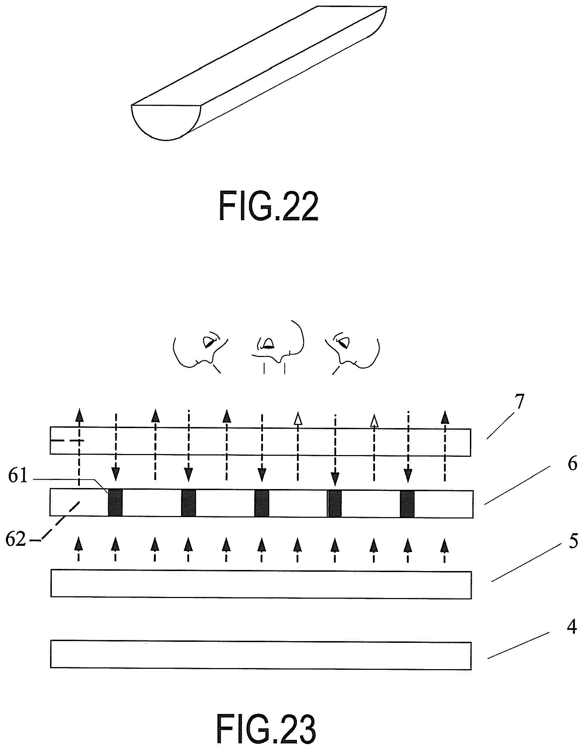

In view of the light transmitting unit with the linear aperture shown in Fig. 11, Fig. 22 provides a linear single concave lenses, which is positioned under the light transmitting unit.

Preferably, the refractive index of the micro lens is a preset refractive index which is determined by the user or development requirements.

Preferably, the supporting layer is a reflector which is used for reflecting the light emitted downward from the backlight layer 5.
Preferably, as illustrated in Fig. 23, the display apparatus also includes a touching layer 7.

The touching layer 7 is located above the display layer 6 and is used for responding to a tap signal.

Preferably, the light transmitting unit 62 is transparent to a preset part of visible light, so that the visible light can transmit through the display apparatus without affecting the transmittance.

After additionally installing the touching layer 7 above the display layer 6, the display apparatus may achieve the function of touching screen. The touching layer 7 responds to a tap signal from the user and transmits the signal to a processor for processing. The touching layer 7 includes, but is not limited to, a resistive touch screen, a capacitive touch screen, etc.

The embodiments of the invention provides a display apparatus, which includes a display layer, a backlight layer and a supporting layer; wherein, the display layer is located above the backlight layer and includes an array formed by photovoltaic materials, the array uniformly forms multiple light transmitting units on the horizontal plane of the display layer, and the photovoltaic materials of the array are connected to form a path for absorbing the light emitted from the backlight layer or the ambient light and convert it into current; the backlight layer provides a light source for the display layer, the supporting layer is positioned under the backlight layer and provides a support for the display layer and the backlight layer. In the display apparatus provided by the embodiments of the invention, the photovoltaic materials are uniformly embedded in the display layer, the array consisting of the photovoltaic materials forms light transmitting units, and the photovoltaic materials forms a path, thus the light emitted from the backlight layer or the ambient light can be absorbed and converted into current without affecting the light emitting of the display layer, and the current obtained by the light conversion is used in a mobile terminal, which can increase the standby time of the mobile terminal and improve the user experience.

### Fourth embodiment

The present embodiment provides a device, which includes the display apparatus according to the third embodiment, and the device receives and uses the current provided by the display apparatus.

In the present embodiment, preferably, the device is a mobile terminal. After the display apparatus provided by the third embodiment is installed as a display screen in the mobile terminal, while using a portable power source, the mobile terminal also can receive the current obtained by the photoelectric conversion in the display apparatus for its operation or receive the current and store it in the portable power source for standby application. Thus, the light source emitted from the display screen itself can be reused and recycled, the maximum efficiency of electrical energy can be achieved, and the standby time of the mobile terminal can be increased, and the user experience can be improved.

In the present embodiment, the device is not limited to the mobile terminal such as a mobile phone, a tablet, a laptop, and it is applicable for any device with a display screen, such as a TV, a desktop computer.

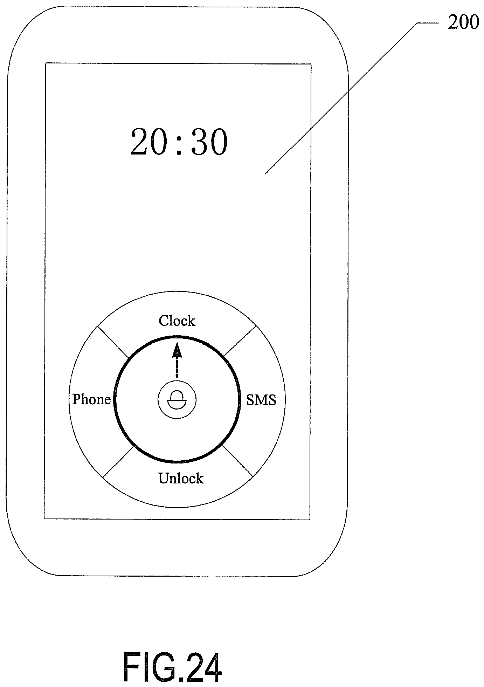

Fig. 24 illustrates a schematic diagram of a mobile phone installed with any one of the display apparatuses according to the third embodiment. The display apparatus 200 is any one of the display apparatuses according to the third embodiment. After the mobile phone is installed with the display screen 200, the photovoltaic material in the display apparatus can form a current loop which is connected with a power source of the mobile phone or an electrical apparatus. When the display apparatus 200 of the mobile phone emits light, the photovoltaic material absorbs the light and converts it to the electrical energy for use by the mobile phone.

The device provided by the present embodiment can operate by using the electrical energy obtained by converting light by the above described display apparatus, and the standby time of the device can be increased and the user experience can be improved without influencing the display effect experienced by the user.

Through the above description to the embodiments, it can be clearly understood by those skilled in the art that, the embodiments of the invention may be implemented by hardware, or by software with necessary common hardware platform. Based on such understanding, the technical solutions of the embodiments of the invention may be embodied in a form of software product which may be stored in a non-volatile storage medium (such as a CD-ROM, a flash disk, or a mobile hard disk) and which may include a series of instructions to enable a computer device (such as a personal computer, a server, or a network device) to implement the method described in the embodiments of the invention.

It could be understood by those skilled in the art that, the accompanying drawings are only illustrative diagrams for the preferred embodiments, and the modules or the procedures in these drawings may not be necessary for implementing the invention.

It could be understood by those skilled in the art that, the modules in a device of the embodiment may be distributed in the device according to the description of the embodiments, or may be correspondingly varied to be contained in one or more device other than that of this embodiment. The modules in the above embodiments may be combined as one module, or may be further divided into several sub-modules.

The aforementioned sequence numbers of the embodiments of the invention are merely for description purpose, not representing the superiority or inferiority of the embodiments.

It is apparent that those skilled in the art may make various modifications and variation to the invention without departing the scope of the invention. Accordingly, if such modification and variation fall within the scope of the claims of the present application or equivalents thereof, the present application intends to embrace such modification and variation.

## Claims

1. A display apparatus, **characterized in that**, the apparatus comprises a light emitting and display layer (1), and a supporting layer (2);
wherein the light emitting and display layer (1) is located above the supporting layer (2) and is used for displaying an image by emitting light;
the supporting layer (2) comprises an array formed by a photovoltaic material (21), the array is located horizontally and directly under driving circuits (11) in the light emitting and display layer (1), and the array formed by the photovoltaic material (21) forms a circuit path for absorbing the light emitted from the light emitting and display layer (1) and convert it into current.

2. The apparatus according to claim 1, **characterized in that**, the supporting layer (2) is made by embedding the photovoltaic material (21) in a reflector.

3. The apparatus according to claim 1, **characterized in that**, the array formed by the photovoltaic material (21) is located horizontally and directly under a preset part of the driving circuits (11) or all of the driving circuits (11) in the light emitting and display layer (1).

4. The apparatus according to claim 1, **characterized in that**, gaps in the array formed by the photovoltaic material (21) totally reflects a preset part of visible light.

5. The apparatus according to claim 1, **characterized in that**, the array formed by the photovoltaic material (21) is obtained by multiple linear photovoltaic material parts being arranged in the horizontal direction of the display apparatus.

6. A display apparatus comprising a backlight layer (5) and a display layer (6);
wherein the display layer (6) is located above the backlight layer (5) and has an array formed by a photovoltaic material (61), the array uniformly forms multiple light transmitting units (62) on the horizontal plane of the display layer (6), and the array formed by the photovoltaic material (61) forms a path for absorbing light emitted from the backlight layer (5) or ambient light and converts it into current;
the backlight layer (5) is used for providing light source for the display layer (6);
**characterized in that** the apparatus further comprises a supporting layer (4) which is located under the backlight layer (5) and is used for providing a support for the display layer (6) and the backlight layer (5), wherein the supporting layer (4) is a reflector which is used for reflecting light emitted downward from the backlight layer (5).

7. The apparatus according to claim 6, **characterized in that**, the light transmitting units (62) are linear apertures (63) or circular apertures (64).

8. The apparatus according to claim 7, **characterized in that**, the light emitting and display layer (1) further comprises micro lenses (610) each of which is correspondingly located under each linear aperture (63), the micro lens (610) is used for focusing light blocked by the photovoltaic material (61) and refracting it to an upward side of the photovoltaic material (61).

9. The apparatus according to claim 8, **characterized in that**, a shape of the micro lens (610) in a top view is a linear shape along the linear aperture (63).

10. The apparatus according to claim 8, **characterized in that**, the refractive index of the micro lens (610) is a preset refractive index.

11. The apparatus according to claim 6 or 14, **characterized in that**, the display apparatus further comprises a touching layer (7),
the touching layer (7) is located above the display layer (6) and is used for responding to a tap signal.

12. The apparatus according to claim 6 or 14, **characterized in that**, the light transmitting units (62) are transparent to a preset part of visible light.

13. The apparatus according to claim 6 or 14, **characterized in that**, the light transmitting units (62) are obtained by multiple linear photovoltaic material parts being arranged in the horizontal direction of the display apparatus.

14. A display apparatus comprising a backlight layer (5) and a display layer (6);
wherein the display layer (6) is located above the backlight layer (5) and has an array formed by a photovoltaic material (61), the array uniformly forms multiple light transmitting units (62) on the horizontal plane of the display layer (6), and the array formed by the photovoltaic material (61) forms a path for absorbing light emitted from the backlight layer (5) or ambient light and converts it into current;
the backlight layer (5) is used for providing light source for the display layer (6);
**characterized in that** the apparatus further comprises a supporting layer (4) which is located under the backlight layer (5);
and **in that** the display layer (6) further comprises an upper polarizer (66), a color glass filter (67), a thin film field effect glass sheet (68) and a lower polarizer (69) in an order from top to bottom;
and **in that** the photovoltaic material (61) is embedded in the upper polarizer (66), the embedding position of the photovoltaic material (61) is directly above a preset part of driving circuits (65) or all of the driving circuits (65) in the display layer (6), and light transmitting units (62) are formed in regions of the upper polarizer (66) except the embedding position.

15. The apparatus according to claim 14, **characterized in that**, the light transmitting units (62) are linear apertures (63) or circular apertures (64).

## Patentansprüche

1. Anzeigevorrichtung, **dadurch gekennzeichnet, dass** die Vorrichtung eine Lichtemissions- und Anzeigeschicht (1) und eine Trägerschicht (2) umfasst,
wobei die Lichtemissions- und Anzeigeschicht (1) sich über der Trägerschicht (2) befindet und zum Anzeigen eines Bildes durch Emittieren von Licht verwendet wird,
die Trägerschicht (2) ein durch ein photovoltaisches Material (21) gebildetes Array umfasst, das Array sich horizontal und direkt unter Antriebsschaltungen (11) in der Lichtemissions- und Anzeigeschicht (1) befindet und das durch das photovoltaische Material (21) gebildete Array einen Schaltungsweg zum Absorbieren des von der Lichtemissions- und Anzeigeschicht (1) emittierten Lichts bildet und es in Strom umwandelt.

2. Vorrichtung nach Anspruch 1, **dadurch gekennzeichnet, dass** die Trägerschicht (2) durch Einbetten des photovoltaischen Materials (21) in einen Reflektor hergestellt wird.

3. Vorrichtung nach Anspruch 1, **dadurch gekennzeichnet, dass** das durch das photovoltaische Material (21) gebildete Array sich horizontal und direkt unter einem voreingestellten Teil der Antriebsschaltungen (11) oder allen der Antriebsschaltungen (11) in der Lichtemissions- und Anzeigeschicht (1) befindet.

4. Vorrichtung nach Anspruch 1, **dadurch gekennzeichnet, dass** Lücken in dem durch das photovoltaische Material (21) gebildeten Array einen voreingestellten Teil von sichtbarem Licht vollständig reflektieren.

5. Vorrichtung nach Anspruch 1, **dadurch gekennzeichnet, dass** das durch das photovoltaische Material (21) gebildete Array durch mehrere lineare photovoltaische Materialteile erhalten wird, die in der horizontalen Richtung der Anzeigevorrichtung angeordnet sind.

6. Anzeigevorrichtung, die eine Hintergrundlichtschicht (5) und eine Anzeigeschicht (6) umfasst,
wobei die Anzeigeschicht (6) sich über der Hintergrundlichtschicht (5) befindet und ein durch ein photovoltaisches Material (61) gebildetes Array aufweist, das Array gleichmäßig mehrere Lichtübertragungseinheiten (62) auf der horizontalen Ebene der Anzeigeschicht (6) bildet und das durch das photovoltaische Material (61) gebildete Array einen Weg zum Absorbieren von Licht, das von der Hintergrundlichtschicht (5) emittiert wird, oder Umgebungslicht bildet und es in Strom umwandelt,
die Hintergrundlichtschicht (5) zum Bereitstellen einer Lichtquelle für die Anzeigeschicht (6) verwendet wird,
**dadurch gekennzeichnet, dass** die Vorrichtung ferner eine Trägerschicht (4) umfasst, die sich unter der Hintergrundlichtschicht (5) befindet und zum Bereitstellen eines Trägers für die Anzeigeschicht (6) und die Hintergrundlichtschicht (5) verwendet wird, wobei die Trägerschicht (4) ein Reflektor ist, der zum Reflektieren von Licht, das von der Hintergrundlichtschicht (5) nach unten emittiert wird, verwendet wird.

7. Vorrichtung nach Anspruch 6, **dadurch gekennzeichnet, dass** die Lichtübertragungseinheiten (62) lineare Öffnungen (63) oder kreisförmige Öffnungen (64) sind.

8. Vorrichtung nach Anspruch 7, **dadurch gekennzeichnet, dass** die Lichtemissions- und Anzeigeschicht (1) ferner Mikrolinsen (610) umfasst, die sich jeweils entsprechend unter jeder linearen Öffnung (63) befinden, wobei die Mikrolinse (610) zum Fokussieren von Licht, das von dem photovoltaischen Material (61) blockiert wird, und Brechen dieses zu einer aufwärtigen Seite des photovoltaischen Materials (61) verwendet wird.

9. Vorrichtung nach Anspruch 8, **dadurch gekennzeichnet, dass** eine Form der Mikrolinse (610) in einer Draufsicht eine lineare Form entlang der linearen Öffnung (63) ist.

10. Vorrichtung nach Anspruch 8, **dadurch gekennzeichnet, dass** der Brechungsindex der Mikrolinse (610) ein voreingestellter Brechungsindex ist.

11. Vorrichtung nach Anspruch 6 oder 14, **dadurch gekennzeichnet, dass** die Anzeigevorrichtung ferner eine Berührungsschicht (7) umfasst,
wobei die Berührungsschicht (7) sich über der Anzeigeschicht (6) befindet und zum Reagieren auf ein Antippsignal verwendet wird.

12. Vorrichtung nach Anspruch 6 oder 14, **dadurch gekennzeichnet, dass** die Lichtübertragungseinheiten (62) für einen voreingestellten Teil von sichtbarem Licht transparent sind.

13. Vorrichtung nach Anspruch 6 oder 14, **dadurch gekennzeichnet, dass** die Lichtübertragungseinheiten (62) durch mehrere lineare photovoltaische Materialteile erhalten werden, die in der horizontalen Richtung der Anzeigevorrichtung angeordnet sind.

14. Anzeigevorrichtung, die eine Hintergrundlichtschicht (5) und eine Anzeigeschicht (6) umfasst,
wobei die Anzeigeschicht (6) sich über der Hintergrundlichtschicht (5) befindet und ein durch ein photovoltaisches Material (61) gebildetes Array aufweist, das Array gleichmäßig mehrere Lichtübertragungseinheiten (62) auf der horizontalen Ebene der Anzeigeschicht (6) bildet und das durch das photovoltaische Material (61) gebildete Array einen Weg zum Absorbieren von Licht, das von der Hintergrundlichtschicht (5) emittiert wird, oder Umgebungslicht bildet und es in Strom umwandelt,
die Hintergrundlichtschicht (5) zum Bereitstellen einer Lichtquelle für die Anzeigeschicht (6) verwendet wird,
**dadurch gekennzeichnet, dass** die Vorrichtung ferner eine Trägerschicht (4) umfasst, die sich unter der Hintergrundlichtschicht (5) befindet,
und dass die Anzeigeschicht (6) ferner einen oberen Polarisator (66), einen Farbglasfilter (67), eine Dünnschicht-Feldeffekt-Glasplatte (68) und einen unteren Polarisator (69) in einer Reihenfolge von oben nach unten umfasst,
und dass das photovoltaische Material (61) in dem oberen Polarisator (66) eingebettet ist, die Einbettungsposition des photovoltaischen Materials (61) direkt über einem voreingestellten Teil von Antriebsschaltungen (65) oder allen der Antriebsschaltungen (65) in der Anzeigeschicht (6) liegt und Lichtübertragungseinheiten (62) in Regionen des oberen Polarisators (66) mit Ausnahme der Einbettungsposition gebildet sind.

15. Vorrichtung nach Anspruch 14, **dadurch gekennzeichnet, dass** die Lichtübertragungseinheiten (62) lineare Öffnungen (63) oder kreisförmige Öffnungen (64) sind.

## Revendications

1. Appareil d'affichage, **caractérisé en ce que** l'appareil comprend une couche d'émission de lumière et d'affichage (1), et une couche de support (2) ;
dans lequel la couche d'émission de lumière et d'affichage (1) est située au-dessus de la couche de support (2) et est utilisée pour afficher une image par émission de lumière ;
la couche de support (2) comprend un réseau formé par un matériau photovoltaïque (21), le réseau est situé horizontalement et directement en dessous de circuits d'excitation (11) dans la couche d'émission de lumière et d'affichage (1), et le réseau formé par le matériau photovoltaïque (21) forme une trajectoire de circuit pour absorber la lumière émise à partir de la couche d'émission de lumière et d'affichage (1) et la convertit en courant.

2. Appareil selon la revendication 1, **caractérisé en ce que** la couche de support (2) est constituée en incorporant le matériau photovoltaïque (21) dans un réflecteur.

3. Appareil selon la revendication 1, **caractérisé en ce que** le réseau formé par le matériau photovoltaïque (21) est situé horizontalement et directement en dessous d'une partie prédéfinie des circuits d'excitation (11) ou de l'ensemble des circuits d'excitation (11) dans la couche d'émission de lumière et d'affichage (1).

4. Appareil selon la revendication 1, **caractérisé en ce que** des espaces dans le réseau formé par le matériau photovoltaïque (21) réfléchissent totalement une partie prédéfinie de la lumière visible.

5. Appareil selon la revendication 1, **caractérisé en ce que** le réseau formé par le matériau photovoltaïque (21) est obtenu par de multiples parties de matériau photovoltaïque linéaires agencées dans la direction horizontale de l'appareil d'affichage.

6. Appareil d'affichage comprenant une couche de rétro-éclairage (5) et une couche d'affichage (6) ;
dans lequel la couche d'affichage (6) est située au-dessus de la couche de rétro-éclairage (5) et possède un réseau formé par un matériau photovoltaïque (61), le réseau forme uniformément de multiples unités de transmission de lumière (62) sur le plan horizontal de la couche d'affichage (6), et le réseau formé par le matériau photovoltaïque (61) forme une trajectoire pour absorber la lumière émise à partir de la couche de rétro-éclairage (5) ou la lumière ambiante et la convertit en courant ;
la couche de rétro-éclairage (5) est utilisée pour fournir une source de lumière pour la couche d'affichage (6) ;
**caractérisé en ce que** l'appareil comprend en outre une couche de support (4) qui est située en dessous de la couche de rétro-éclairage (5) et est utilisée pour fournir un support pour la couche d'affichage (6) et la couche de rétro-éclairage (5), dans lequel la couche de support (4) est un réflecteur qui est utilisé pour réfléchir la lumière émise vers le bas à partir de la couche de rétro-éclairage (5).

7. Appareil selon la revendication 6, **caractérisé en ce que** les unités d'émission de lumière (62) sont des ouvertures linéaires (63) ou des ouvertures circulaires (64).

8. Appareil selon la revendication 7, **caractérisé en ce que** la couche d'émission de lumière et d'affichage (1) comprend en outre des microlentilles (610), chacune d'elles est située de manière correspondante en dessous de chaque ouverture linéaire (63), la microlentille (610) est utilisée pour focaliser la lumière bloquée par le matériau photovoltaïque (61) et la réfracter vers un côté amont du matériau photovoltaïque (61).

9. Appareil selon la revendication 8, **caractérisé en ce qu'**une forme de la microlentille (610) sur une vue de dessus est une forme linéaire le long de l'ouverture linéaire (63).

10. Appareil selon la revendication 8, **caractérisé en ce que** l'indice de réfraction de la microlentille (610) est un indice de réfraction prédéfini.

11. Appareil selon la revendication 6 ou 14, **caractérisé en ce que** l'appareil d'affichage comprend en outre une couche de contact (7),
la couche de contact (7) est située au-dessus de la couche d'affichage (6) et est utilisée pour répondre à un signal de toucher.

12. Appareil selon la revendication 6 ou 14, **caractérisé en ce que** les unités d'émission de lumière (62) sont transparentes à une partie prédéfinie de lumière visible.

13. Appareil selon la revendication 6 ou 14, **caractérisé en ce que** les unités d'émission de lumière (62) sont obtenues par de multiples parties de matériau photovoltaïque linéaires agencées dans la direction horizontale de l'appareil d'affichage.

14. Appareil d'affichage comprenant une couche de rétro-éclairage (5) et une couche d'affichage (6) ;
dans lequel la couche d'affichage (6) est située au-dessus de la couche de rétro-éclairage (5) et possède un réseau formé par un matériau photovoltaïque (61), le réseau forme uniformément de multiples unités d'émission de lumière (62) sur le plan horizontal de la couche d'affichage (6), et le réseau formé par le matériau photovoltaïque (61) forme une trajectoire pour absorber la lumière émise à partir de la couche de rétro-éclairage (5) ou la lumière ambiante et la convertit en courant ;
la couche de rétro-éclairage (5) est utilisée pour fournir une source de lumière pour la couche d'affichage (6) ;
**caractérisé en ce que** l'appareil comprend en outre une couche de support (4) qui est située en dessous de la couche de rétro-éclairage (5) ;
et **en ce que** la couche d'affichage (6) comprend en outre un polariseur supérieur (66), un filtre en verre coloré (67), une feuille de verre à effet de champ en couches minces (68) et un polariseur inférieur (69) dans un ordre de haut en bas ;
et **en ce que** le matériau photovoltaïque (61) est incorporé dans le polariseur supérieur (66), la position d'incorporation du matériau photovoltaïque (61) est directement au-dessus d'une partie prédéfinie des circuits d'excitation (65) ou de l'ensemble des circuits d'excitation (65) dans la couche d'affichage (6), et des unités d'émission de lumière (62) sont formées dans des régions du polariseur supérieur (66) à l'exception de la position d'incorporation.

15. Appareil selon la revendication 14, **caractérisé en ce que** les unités d'émission de lumière (62) sont des ouvertures linéaires (63) ou des ouvertures circulaires (64).
